# EUROPÄISCHE PATENTSCHRIFT

(11) **EP 1 873 903 B1**
(45) Veröffentlichungstag und Bekanntmachung des Hinweises auf die Patenterteilung: **02.05.2012**
(21) Anmeldenummer: 07012427.6
(22) Anmeldetag: 26.06.2007
(51) Int. Cl.: H03B 11/02

(54) **Mikrowellengenerator**
Microwave generator
Générateur de micro-ondes

(30) Priorität: 01.07.2006 DE 102006030514
(43) Veröffentlichungstag der Anmeldung: 02.01.2008
(73) Patentinhaber: Diehl BGT Defence GmbH & Co.KG, 88662 Überlingen (DE)
(72) Erfinder: Stark, Robert, Dr., 91438 Bad Windsheim (DE); Urban, Jürgen, Dr., 91056 Erlangen (DE)
(74) Vertreter: Diehl Patentabteilung

(56) Entgegenhaltungen:
- EP-A- 1 473 866
- WO-A1-2007/082687
- HONG K ET AL INSTITUTE OF ELECTRICAL AND ELECTRONICS ENGINEERS: "DEVELOPMENT OF ANTENNA-SOURCE SYSTEM FOR GENERATION OF HIGH-POWER ELECTROMAGNETIC PULSES" PPPS-2001. PULSED POWER PLASMA SCIENCE 2001.DIGEST OF TECHNICAL PAPERS. ( THE 28TH. IEEE INT. CONF. ON PLASMA SCIENCE: ICOPS/THE 13TH.IEEE INT. PULSED POWER CONFERENCE: PPC). LAS VEGAS, NV, JUNE 17 - 22, 2001, IEEE PULSED POWER PLASMA SCIENCE CONFERE, Bd. VOL. 1 OF 2, 17. Juni 2001 (2001-06-17), Seiten 203-206, XP001113855 ISBN: 0-7803-7120-8

## Beschreibung

Die Erfindung betrifft einen Mikrowellengenerator gemäß dem Oberbegriff des Anspruches 1. Ein solcher Mikrowellengenerator ist aus der WO2007/082687 A1 bekannt.

Die Funktion eines solchen Mikrowellengenerators beruht darauf, dass eine Hochspannungsquelle über eine Funkenstrecke des Mikrowellengenerators kurzgeschlossen und damit entladen wird. Die Hochspannungsquelle kann eine nach dem Prinzip der Marx'schen Stoßspannungsschaltung parallel aufgeladene und dann in Serie geschaltete Kondensatorbatterie aufweisen. Alternativ zur Verwendung einer Marx'schen Stoßspannungsschaltung, d. h. eines Marx-Generators, kann auch ein explosionsstoffgetriebener Hochspannungsgenerator zur Anwendung gelangen, der einen einzelnen Hochspannungspuls mit extrem hoher Pulsenergie zur Verfügung stellen kann.

Infolge des Kurzschlusses der Hochspannungsquelle über die Funkenstrecke entstehen stark oszillierende Entlade- bzw. Kurzschluss-Ströme mit einer steilen Flanke, die eine Mischung sehr hoher Frequenzen enthalten, die über ein eine Antenne bildendes Abstrahlelement des Mikrowellengenerators als Mikrowellenenergie mit einem breitbandigen, vom jeweiligen Frequenzgemisch abhängigen Spektrum abgestrahlt werden. Das breitbandige Mikrowellenspektrum weist eine sehr hohe Energiedichte auf, so dass in der Umgebung eines solchen Mikrowellengenerators beispielsweise der Funkverkehr zumindest beeinträchtigt bzw. Eingangskreise elektronischer Schaltungen auf Grund von Resonanzeffekten gestört oder im Extremfall sogar zerstört werden können.

Aus der DE 101 51 565 A1 ist ein Mikrowellengenerator bekannt, der zwischen axial fluchtend angeordneten Elektroden eine Hochspannungs-Funkenstrecke aufweist.

Beiderseits der Funkenstrecke sind die Elektroden und ihre koaxialen Halterungen zumindest über einen Teil ihrer axialen Längenausdehnung von einem distanziert dazu verlaufenden elektrischen Leiter begleitet, der an eine der beiden Elektroden elektrisch leitend angeschlossen ist. Die Funkenstrecke ist bei diesem bekannten Mikrowellengenerator zwischen einer kleinen pilzkappenförmigen Elektrode und einer größeren keulenartigen Elektrode gebildet. Die keulenartige Elektrode ist von einem äußeren Leiter umgeben, der über eine entsprechende Verbindungsstruktur mit der pilzkappenförmigen Elektrode verbunden ist. Die Verbindungsstruktur kann gemeinsam mit der pilzkappenförmigen Elektrode über einen Spindelmechanismus in ihrer axialen Position relativ zur feststehenden zweiten Elektrode zu Abstimmzwecken verschoben werden.

Aus der älteren DE-Patentanmeldung 10 2005 002 279 ist ein Mikrowellengenerator mit einer Zentralelektrode, die vorderseitig ein Abstrahlelement aufweist, und mit einer die Zentralelektrode entlang eines sich axial erstreckenden Resonatorabschnittes koaxial umschließenden Außenelektrode bekannt, wobei die beiden Elektroden rotationssymmetrisch ausgebildet sind und eine Funkenstrecke bestimmen, die bei Anliegen einer Hochspannung durchschlägt und über das Abstrahlelement der Zentralelektrode Mikrowellen emittiert. Dieser Mikrowellengenerator besteht im Wesentlichen aus den beiden metallischen Elektroden, nämlich der Zentralelektrode mit dem Abstrahlelement, und der diese koaxial umschließenden Außenelektrode. Die beiden Elektroden sind in einer elektrisch isolierenden Gehäusehülse abdichtend angeordnet und können durch einfaches Kontaktieren an den beiden axial voneinander entfernten Enden des Mikrowellengenerators mit einer gepulsten Hochspannungsquelle aufgeladen werden. Hierbei handelt es sich um eine sogenannte Zweidrahtspeisung des Mikrowellengenerators. Der durch die beiden Elektroden und die elektrisch isolierende Gehäusehülse bestimmte und abdichtend begrenzte Innenraum des Mikrowellengenerators kann zur Erhöhung der Spannungsfestigkeit mit einem gasförmigen oder mit einem flüssigen Dielektrikum gefüllt sein. Bei dem gasförmigen Dielektrikum handelt es sich z.B. um SF₆.

Aus der EP 1 473 866 A1 ist ein ähnliche Mikrowellengenerator mit einem Marx-Generator auch bekannt.

Dieses Dokument fällt unter Art. 54(3) EPÜ; es ist daher für die Frageder erfinderischen Tätigkeit nicht von Bedeutung

Bei dem Mikrowellengenerator der zuletzt genannten Art ist die Hochspannungsquelle vorzugsweise von einem Marx-Generator gebildet, der seitlich neben dem Mikrowellengenerator und zu diesem parallel angeordnet ist, so dass die an den voneinander entfernten Enden des Marx-Generators vorgesehenen Spannungsausgänge an die axial voneinander abgewandten Enden des Mikrowellengenerators angeschlossen werden können. Das gewährleistet zwar eine optimale Spannungsfestigkeit, der Platz- d.h. Raumbedarf ist durch die Anordnung der Hochspannungsquelle seitlich neben dem Mikrowellengenerator jedoch entsprechend groß.

Der Erfindung liegt die Aufgabe zugrunde, einen Mikrowellengenerator der eingangs genannten Art zu schaffen, bei dem der Platz- d.h. Raumbedarf vergleichsweise klein ist, d.h. der sehr kompakt ausgebildet ist.

Diese Aufgabe wird erfindungsgemäß durch die Merkmale des Anspruches 1 gelöst. Bevorzugte Aus- bzw. Weiterbildungen des erfindungsgemäßen Mikrowellengenerators sind in den Unteransprüchen gekennzeichnet.

Dadurch, dass bei dem erfindungsgemäßen Mikrowellengenerator die Hochspannungsquelle sich nicht außerhalb des Mikrowellengenerators sondern in seinem Inneren befindet, ist der Platz- d.h. Raumbedarf entsprechend klein, d.h. erfindungsgemäß ist ein ultrakompakter Mikrowellengenerator realisierbar.

Der erfindungsgemäße ultrakompakte Mikrowellengenerator kann beispielsweise in ein Fahrzeug verbracht und zu einem gewünschten Zeitpunkt per Funk ausgelöst werden. Auf diese Weise ist z.B. ein gezieltes Stoppen des Fahrzeuges möglich. Eine andere Anwendungsmöglichkeit für den erfindungsgemäßen Mikrowellengenerator ist der Indoor-Einsatz z.B. gegen Computer, Überwachungssysteme, Alarmanlagen o. dgl. Bei einem solchen Einsatz ist der Mikrowellengenerator z.B. von Sonderkräften in ein Gebäude einzubringen und kann bei einem gewünschten späteren Zugriff per Funk aktiviert werden.

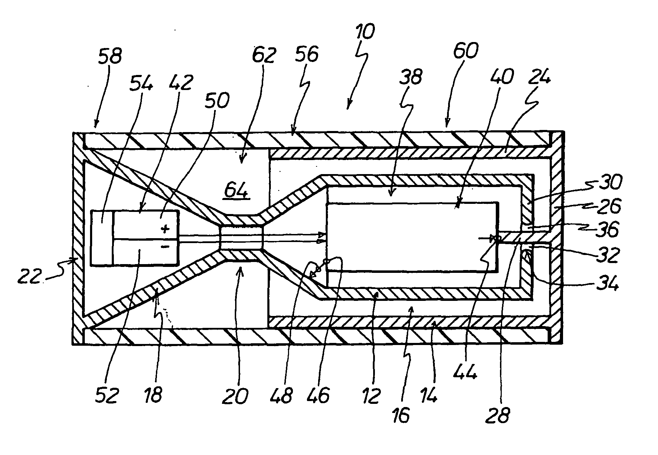

Weitere Einzelheiten, Merkmale und Vorteile ergeben sich aus der nachfolgenden Beschreibung eines in der Zeichnung schematisch in einer Längsschnittdarstellung verdeutlichten Ausführungsbeispieles des erfindungsgemäßen Mikrowellengenerators.

Die Figur zeigt eine Ausbildung des erfindungsgemäßen Mikrowellengenerators 10, der eine hohle Zentralelektrode 12 und eine Außenelektrode 14 aufweist. Die hohle Zentralelektrode 12 und die diese koaxial umschließende Außenelektrode 14 bestimmen einen sich axial erstreckenden Resonatorabschnitt 16 des Mikrowellengenerators 10.

An die hohle Zentralelektrode 12 schließt vorderseitig materialeinstückig ein hohles Abstrahlelement 18 an. Das Abstrahlelement 18 erweitert sich von einer Verengung 20 nach vorne und ist vorderseitig durch eine Stirnwand 22 dicht abgeschlossen.

Die Außenelektrode 14 ist topfförmig mit einer Zylinderwand 24 und einem rückseitigen Boden 26 ausgebildet. Vom Boden 26 erstreckt sich zentral materialeinstückig ein Anschlusselement 28 nach vorne. Die hohle Zentralelektrode 12 weist rückseitig eine Bodenwand 30 mit einem zentralen Durchgangsloch 32 auf. Das vom Boden 26 der Außenelektrode 14 wegstehende Anschlusselement 28 erstreckt sich durch das zentrale Durchgangsloch 32 in der Bodenwand 30 der Zentralelektrode 12 mittig hindurch. Zwischen dem Anschlusselement 28 und dem Ringrand 34 des zentralen Durchgangsloches 32 im Boden 30 der Zentralelektrode 12 ist somit eine Ringfunkenstrecke 36 gebildet.

An die beiden rotationssymmetrischen Elektroden 12 und 14 des Mikrowellengenerators 10 ist eine Hochspannungsquelle 38 angeschlossen, die einen Marx-Generator 40 und eine elektrische Energieversorgungseinrichtung 42 für den Marx-Generator 40 aufweist. Der Marx-Generator 40 besitzt einen Hochspannungslmpulsausgang 44 und einen Hochspannungs-Masseausgang 46. Der Hochspannungs-Impulsausgang 44 des Marx-Generators 40 ist mit dem Anschlusselement 28 der Außenelektrode 14 des Mikrowellengenerators 10 kontaktiert. Der Hochspannungs-Masseausgang 46 des Marx-Generators 40 ist mit der Zentralelektrode 12 verbunden. Das ist durch den Pfeil 48 angedeutet.

Der Marx-Generator 40 ist im Inneren der hohlen Zentralelektrode 12 angeordnet und die elektrische Energieversorgungseinrichtung 42 für den Marx-Generator 40 ist im hohlen Abstrahlelement 18 des Mikrowellengenerators 10 angeordnet.

Die elektrische Energieversorgungseinrichtung 42 weist zwei DCDC-Hochspannungswandler 50 und 52 auf, die von einer Batterie 54 gespeist werden.

Eine aus einem elektrisch isolierenden Material bestehende Gehäusehülse 56 ist mit ihrem Vorderende 58 mit dem hohlen Abstrahlelement 18 abdichtend fest verbunden. Die Gehäusehülse 56 ist mit ihrem rückseitigen Endabschnitt 60 mit der Außenelektrode 14 abdichtend fest verbunden, so dass sich ein abgedichteter Innenraum 62 ergibt, der vorderseitig durch die Stirnwand 22 des Abstrahlelementes 18, rückseitig durch den Boden 26 der Außenelektrode 14 und umfangsseitig durch die Gehäusehülse 56 bestimmt ist. Der Innenraum 62 ist zur Erhöhung der Spannungsfestigkeit des Mikrowellengenerators 10 mit einem gasförmigen oder mit einem flüssigen Dielektrikum 64 gefüllt.

Durch die Integration der Hochspannungsquelle 38, d.h. des Marx-Generators 40 und der zugehörigen elektrischen Energieversorgungseinrichtung 42 in den Innenraum 62 des Mikrowellengenerators 10 ergibt sich in vorteilhafter Weise im Vergleich zu einer Zweidraht-Endeinspeisung und im Vergleich zu einer axial fluchtenden d.h. koaxialen Einspeisung ein ultrakompakter Mikrowellengenerator 10.

### Bezugsziffernliste:

- 10: Mikrowellengenerator
- 12: Hohle Zentralelektrode (von 10)
- 14: Außenelektrode (von 10)
- 16: Resonatorabschnitt (von 10 zwischen 12 und 14)
- 18: Hohles Abstrahlelement (an 12)
- 20: Verengung (zwischen 12 und 18)
- 22: Stirnwand (von 18)
- 24: Zylinderwand (von 14)
- 26: Rückseitiger Boden (von 14)
- 28: Anschlusselement (an 26 für 44)
- 30: Rückseitige Bodenwand (von 12)
- 32: Zentrales Durchgangsloch (in 30)
- 34: Ringrand (von 32)
- 36: Ringfunkenstrecke (zwischen 34 und 28)
- 38: Hochspannungsquelle (für 10)
- 40: Marx-Generator (von 38)
- 42: Elektrische Energieversorgungseinrichtung (für 40)
- 44: Hochspannungs-Impulsausgang (von 40)
- 46: Hochspannungs-Masseausgang (von 40)
- 48: Pfeil/Verbindung (zwischen 46 und 12)
- 50: DCDC-Hochspannungswandler (von 42)
- 52: DCDC-Hochspannungswandler (von 42)
- 54: Batterie (für 42)
- 56: Gehäusehülse (von 10)
- 58: Vorderende (von 56)
- 60: Rückseitiger Endabschnitt (von 56)
- 62: Innenraum (von 10 zwischen 56, 22 und 26)
- 64: Dielektrikum (in 62)

## Patentansprüche

1. Mikrowellengenerator mit einer hohlen Zentralelektrode (12), die vorderseitig ein hohles Abstrahlelement (18) aufweist, und mit einer die Zentralelektrode (12) entlang eines sich axial erstreckenden Resonatorabschnittes (16) koaxial umschließenden Außenelektrode (14), wobei die beiden Elektroden (12 und 14) eine Funkenstrecke (36) bestimmen und an eine Hochspannungsquelle (38), welche einen Marx-Generator (40) und eine elektrische Energieversorgungseinrichtung (42) für den Marx-Generator (40) aufweist, angeschlossen sind,
wobei die Hochspannungsquelle (38) in der hohlen Zentralelektrode (12) angeordnet ist,
**dadurch gekennzeichnet,**
**dass** die elektrische Energieversorgungseinrichtung (42) zwei DCDC-Hochspannungswandler (50, 52) aufweist, die von einer Batterie (54) gespeist werden.

2. Mikrowellengenerator nach Anspruch 1,
**dadurch gekennzeichnet,**
**dass** der Marx-Generator (40) im Resonatorabschnitt (16) der Zentralelektrode (12) und die elektrische Energieversorgungseinrichtung (42) im hohlen Abstrahlelement (18) angeordnet ist.

3. Mikrowellengenerator nach Anspruch 2,
**dadurch gekennzeichnet,**
**dass** die Außenelektrode (14) topfförmig mit einer Zylinderwand (24) und mit einem Boden (26) ausgebildet ist, wobei sich vom Boden (26) zentral materialeinstückig ein Anschlusselement (28) nach vorne erstreckt, das mit dem Hochspannungs-Impulsausgang (44) des Marx-Generators (40) kontaktiert ist, und dass die mit dem Hochspannungs-Masseausgang (46) verbundene Zentralelektrode (12) rückseitig eine Bodenwand (30) mit einem zentralen Durchgangsloch (32) aufweist, durch das sich das Anschlusselement (28) der Außenelektrode (14) hindurch erstreckt, so dass zwischen dem Anschlusselement (28) und dem Ringrand (34) des Durchgangsloches (32) eine Ringfunkenstrecke (36) gebildet ist.

4. Mikrowellengenerator nach einem der Ansprüche 1 bis 3,
**dadurch gekennzeichnet,**
**dass** die Außenelektrode (14) eine Gehäusehülse (56) aus elektrisch isolierendem Material rückseitig und die Zentralelektrode (12) mit ihrem Abstrahlelement (18) die Gehäusehülse (56) vorderseitig abdichtend fest verschließt.

5. Mikrowellengenerator nach Anspruch 4,
**dadurch gekennzeichnet,**
**dass** der durch die Gehäusehülse (56) bestimmte Innenraum (62) des Mikrowellengenerators (10) mit einem gasförmigen oder einem flüssigen Dielektrikum (64) gefüllt ist.

6. Mikrowellengenerator nach einem der Ansprüche 1 bis 5,
**dadurch gekennzeichnet,**
**dass** das Abstrahlelement (18) vorderseitig durch eine Stirnwand (22) verschlossen ist.

## Claims

1. Microwave generator having a hollow central electrode (12) whose front face has a hollow emission element (18), and having an outer electrode (14), which coaxially surrounds the central electrode (12) along an axially extending resonator section (16), with the two electrodes (12 and 14) defining a spark gap (36) and being connected to a high-voltage source (38), which has a Marx generator (40) and an electrical power supply device (42) for the Marx generator (40), with the high-voltage source (38) being arranged in the hollow central electrode (12),
**characterized**
**in that** the electrical power supply device (42) has two DC/DC high-voltage converters (50, 52), which are powered by a battery (54).

2. Microwave generator according to Claim 1,
**characterized**
**in that** the Marx generator (40) is arranged in the resonator section (16) of the central electrode (12), and the electrical power supply device (42) is arranged in the hollow emission element (18).

3. Microwave generator according to Claim 2,
**characterized**
**in that** the outer electrode (14) is in the form of a pot with a cylindrical wall (24) and with a base (26), with a connecting element (28) extending forwards, centrally and integrally with the material, from the base (26) and making contact with the high-voltage pulse output (44) of the Marx generator (40), and in that the central electrode (12) which is connected to the high-voltage earth output (46) has a base wall (30) on the rear face with a central aperture hole (32) which extends through the connecting element (28) of the outer electrode (14), such that an annular spark gap (36) is formed between the connecting element (28) and the annular edge (34) of the aperture hole (32).

4. Microwave generator according to one of Claims 1 to 3,
**characterized**
**in that** the outer electrode (14) firmly closes a housing sleeve (56) composed of electrically insulating material on the rear face, and the emission element (18) of the central electrode (12) firmly closes the housing sleeve (56) on the front face, forming a seal.

5. Microwave generator according to Claim 4,
**characterized**
**in that** the internal area (62), which is defined by the housing sleeve (56), of the microwave generator (10) is filled with a gaseous or a liquid dielectric (64).

6. Microwave generator according to one of Claims 1 to 5,
**characterized**
**in that** the emission element (18) is closed on the front face by an end wall (22).

## Revendications

1. Générateur de micro-ondes comprenant une électrode centrale (12) creuse qui présente du côté avant un élément rayonnant (18) creux, et comprenant une électrode externe (14) qui entoure l'électrode centrale (12) de manière coaxiale le long d'une section de résonateur (16) qui s'étend dans le sens axial, les deux électrodes (12 et 14) déterminant une distance de décharge (36) et étant raccordées à une source de haute tension (38) qui présente un générateur de Marx (40) et un dispositif d'alimentation en énergie électrique (42) pour le générateur de Marx (40),
la source de haute tension (38) étant disposée dans l'électrode centrale (12) creuse,
**caractérisé en ce que** le dispositif d'alimentation en énergie électrique (42) présente deux convertisseurs de haute tension CC/CC (50, 52) qui sont alimentés par une batterie (54).

2. Générateur de micro-ondes selon la revendication 1, **caractérisé en ce que** le générateur de Marx (40) est disposé dans la section de résonateur (16) de l'électrode centrale (12) et le dispositif d'alimentation en énergie électrique (42) dans l'élément rayonnant (18) creux.

3. Générateur de micro-ondes selon la revendication 2, **caractérisé en ce que** l'électrode externe (14) est réalisée en forme de pot avec une paroi cylindrique (24) et avec un fond (26), un élément de raccordement (28) s'étendant d'une seule pièce matérielle vers l'avant au centre depuis le fond (26), celui-ci étant en contact avec la sortie d'impulsions à haute tension (44) du générateur de Marx (40), et **en ce que** l'électrode centrale (12) reliée avec la sortie de masse de haute tension (46) présente du côté arrière une paroi de fond (30) munie d'un trou traversant (32) central à travers lequel s'étend l'élément de raccordement (28) de l'électrode externe (14), de sorte qu'une distance de décharge annulaire (36) soit formée entre l'élément de raccordement (28) et le bord annulaire (34) du trou traversant (32).

4. Générateur de micro-ondes selon l'une des revendications 1 à 3, **caractérisé en ce que** l'électrode externe (14) ferme à demeure et de manière étanche un manchon de boîtier (56) en matériau électriquement isolant du côté arrière et l'électrode centrale (12), avec son élément rayonnant (18), le manchon de boîtier (56) du côté avant.

5. Générateur de micro-ondes selon la revendication 4, **caractérisé en ce que** l'espace intérieur (62) du générateur de micro-ondes (10) déterminé par le manchon de boîtier (56) est rempli d'un diélectrique (64) gazeux ou liquide.

6. Générateur de micro-ondes selon l'une des revendications 1 à 5, **caractérisé en ce que** l'élément rayonnant (18) est fermé du côté avant par une paroi frontale (22).
